(19) Europäisches Patentamt
European Patent Office
Office européen des brevets

(11) Publication number: **0 315 341 B1**

(12) **EUROPEAN PATENT SPECIFICATION**

(45) Date of publication of patent specification: **19.11.92**

(51) Int. Cl.5: **C09D 183/04**, C08L 83/06, C08F 299/08, B05D 3/06

(21) Application number: **88309841.0**

(22) Date of filing: **20.10.88**

(54) **Compositions having uv cure with moisture shadow cure.**

(30) Priority: **06.11.87 US 118146**
**01.06.88 US 200827**

(43) Date of publication of application:
**10.05.89 Bulletin 89/19**

(45) Publication of the grant of the patent:
**19.11.92 Bulletin 92/47**

(84) Designated Contracting States:
**BE DE FR GB IT NL**

(56) References cited:
**EP-A- 0 070 746**
**EP-A- 0 230 342**

(73) Proprietor: **DOW CORNING CORPORATION**
**3901 S. Saginaw Road**
**Midland Michigan 48686-0995(US)**

(72) Inventor: **Gutek, Beth Irene**
**9791 Dice Road**
**Freeland Michigan(US)**

(74) Representative: **Lewin, John Harvey et al**
**Elkington and Fife Prospect House 8 Pembroke Road**
**Sevenoaks, Kent TN13 1XR(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services

## Description

This invention relates to a coating composition which can cure by exposure to ultraviolet radiation and also has capabilities of curing by exposure to moisture at room temperature. The ability to cure at room temperature provides the coating composition with a characteristic which allows it to be used for coating application where the possibility of exposing all the area of a coated substrate with ultraviolet radiation are so unlikely, so impractical, that one may say it is impossible. This cure process which cures without the exposure to ultraviolet radiation can be termed "shadow cure" or "dark cure" meaning cure which occurs without being exposed to the ultraviolet radiation, i.e. cures in the shadow of the exposure or in the dark areas when the ultraviolet radiation is directed on the substrate.

Compositions which cure by exposure to ultraviolet radiation are well known in the art, although the number of such materials found in commercial usage today are still relatively small. An even smaller number of such compositions are known to the art which both cure by exposure to ultraviolet radiation and also by another mechanism, such as by heat. Compositions which cure by two mechanisms are said to have dual cure.

Compositions which cure by exposure to ultraviolet radiation and by exposure to moisture, i.e. a dual cure, are also known in the art as shown by Lien et al. in U.S. Patent No. 4,528,081 issued July 9, 1985. Lien et al. describe a dual curing silicone composition which contains an acrylic functional dialkoxy or diaryloxy silyl group terminated polyorganosiloxane, an effective amount of a photosensitizer, and a silicone moisture curing catalyst. These compositions of Lien et al. can also contain trimethylsilyl terminated silicone oil. Lien et al. describe their materials as curing to soft gel like materials or soft rubbery materials. In their examples, the cured materials are defined as a soft rubbery material at 0% oil to a very soft sticky gel at 70% oil which showed a tendency to creep but would not flow.

The present invention is a composition which has dual cure mechanisms, i.e. it cures by exposure to ultraviolet radiation and also cures by exposure to moisture.

This invention relates to a composition comprising (A) at least 10 weight percent based on the total weight of the composition of an acrylamide polyorganosiloxane having at least two groups which have acrylamide group functionality bonded to silicon atoms through Si-C bonds and on the average at least 20 but less than 1500 siloxane units per molecule, the organic groups bonded to the silicon atoms other than those having the acrylamide group functional are selected from the group consisting of methyl, ethyl, propyl and phenyl, (B) at least 20 weight percent based on the total weight of the composition of a polydiorganosiloxane having endgroups where there are two alkoxy groups per endgroup bonded to silicon through an Si-O bond and one methacrylate group bonded to silicon atoms through Si-C bonds and having on the average less than 350 diorganosiloxane units per molecule, said diorganosiloxane units being selected from dimethylsiloxane units, diphenylsiloxane units, and methylphenylsiloxane units wherein at least 50 percent of the organic groups of the diorganosiloxane are methyl, (C) from 0.5 to 10 weight percent based on the total weight of the composition of a photoinitiator which is compatible with (A) and (B), and (D) a catalytic quantity of an organic titanate sufficient to cause a curing reaction when exposed to moisture after the composition is exposed to ultraviolet radiation.

The acrylamide polyorganosiloxane (A) contains at least 20 siloxane units and, as many as, 1500 siloxane units. These siloxane units contain at least two acrylamide functional groups which are bonded to silicon atoms through Si-C bonds. The acrylamide functional groups can be either on the terminal silicon atoms of the polymer chain or they can be pendent on silicon atoms along the polymer chain. The remaining organic groups bonded to the silicon atoms of the polyorganosiloxane are methyl, ethyl, propyl or phenyl, where the methyl are preferred for economical reasons, the combinations of methyl and phenyl can be useful for providing compatible compositions with reactive diluents and photo-initiators. The acrylamide functional polydiorganosiloxanes are known in the art from Varaprath in U.S. Patent No. 4,608,270, issued August 26, 1986, which shows the polyorganosiloxanes with acrylamide functionality and the methods of making such polymers. The polyorganosiloxanes which are useful in the present invention are those which have from 20 to 1500 siloxane units and at least two acrylamide groups. The siloxane units can include dimethylsiloxane units diphenylsiloxane units methylphenylsiloxane units, trimethylsiloxy units, phenylsilsesquioxane units, propylsilsesquioxane units, methylsilsesquioxane units, methylethylsiloxane units, dimethylphenylsiloxy units, and siloxane units of the formula

$$ZAN(Q'AN)_bQ\overset{\displaystyle R'_a}{\overset{|}{Si}}O_{(3-a)/2}$$

in which Z is H or R, R is a monovalent hydrocarbon radical, R′ is methyl or phenyl, Q and Q′ are divalent hydrocarbon radicals, A is an acyl radical having the formula

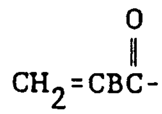

where B is H or $CH_3$, $\underline{a}$ is 1 or 2, and $\underline{b}$ is 0 or 1. The monovalent hydrocarbon radicals, R, can be alkyl radicals such as methyl, ethyl, propyl, butyl, hexyl, and octyl; cycloaliphatic radicals such as cyclohexyl; aryl radicals such as phenyl, benzyl, styryl, tolyl, and xenyl; and alkenyl radicals such as vinyl and allyl. Q and Q′ are divalent hydrocarbon radicals such as ethylene, propylene, isopropylene, butylene, isobutylene, hexylene, octylene, and phenylene. Q is preferably ethylene and Q′ is preferably propylene or isobutylene. When B is hydrogen, the acyl radical is acrylyl radical and when B is methyl, the acyl radical is methacrylyl radical. Polydimethylsiloxanes endblocked with

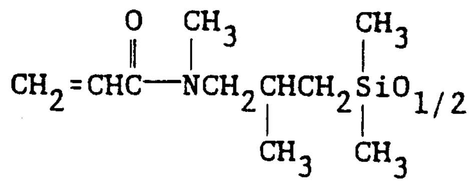

are preferred when the molecular weight is on the low end of the range, such as from 50 to 250 siloxane units, and when low viscosities are desired. The polydimethylsiloxanes which contain pendent or both pendent and terminal acrylamide functional groups are preferred when a higher crosslinked density is desired, such as to make tougher materials. The preferred polydiorganosiloxanes in the present compositions provide compositions which cure by the dual mechanism to coatings which exhibit a tougher material than when the lower molecular weight polydiorganosiloxanes are used.

The polydiorganosiloxane (B) contains dimethylsiloxane units, diphenylsiloxane units and methylphenylsiloxane units to provide on the average less than 350 siloxane units, preferably less than 100 siloxane units. The polydiorganosiloxane (B) is preferably endblocked with (gamma-methacryloxyalkyl)-dimethoxysiloxy units where the alkyl is preferably propylene or isobutylene. These Polydiorganosiloxanes of (B) can be prepared, for example, by mixing hydroxyl endblocked polydiorganosiloxane, a silane such as gamma-methacryloxypropyltrimethoxysilane or gamma-methacryloxyisobutyltrimethoxysilane, in the presence of a catalytic amount of alcoholic potassium hydroxide. It is recommended that a polymerization inhibitor be used during this process and can include such compounds as phenothiazine and para-methoxyphenol. A slight excess of the theoretical amount of silane is recommended to ensure complete reaction, such as 10 weight percent excess. The ingredients are mixed and heated to remove the stoichiometric amount of methanol (in this illustrated method). After the stoichiometric amount of alcohol is removed, the resulting mixture is neutralized with acetic acid. The polydiorganosiloxanes of (B) have a general formula

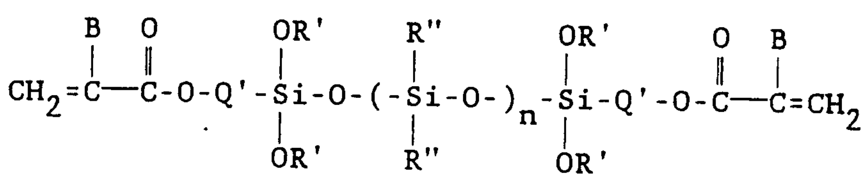

where B is H or methyl, Q′ is a divalent alkylene radical such as propylene or isobutylene, R′ is an alkyl radical such as methyl, ethyl or propyl, each R″ is methyl or phenyl, and $\underline{n}$ is an average value of less than 350. The resulting polydiorganosiloxane (B) made from the process defined herein may contain some unreacted silane because an excess is used. Because such an excess is usually in the range of less than 20 weight percent, the compositions of this invention can include the excess silane, such as from 5 to 15 weight percent based on the weight of the product of the process.

The photoinitiator (C) is one which is compatible with a combination of (A) and (B) and which will function in the presence of organic titanate. Photoinitiators which are useful in these compositions include

$C_6H_5-C(O)C(CH_3)_2-OH$,

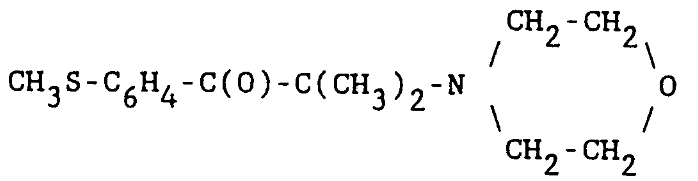

,

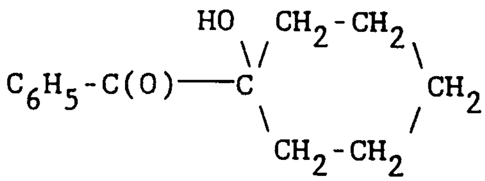

,

and benzoin methyl ether.

The organic titanate catalyst of (D) Provides the moisture curability for the composition and can be any of the conventional organic titanates such as tetraisopropyl titanate, tetrabutyl titanate, bis(acetylacetonate)-diisopropyl titanate, and bis(ethoxyacetylacetonate)diisopropyl titanate. The amount of the organic titanate should be sufficient enough to catalyst the composition when exposed to atmospheric moisture after having been exposed to ultraviolet radiation. Thus, any organic titanate which undergoes some reaction from ultraviolet radiation may not be suitable if it looses its ability to cause the curing reaction in the shadowed areas. Also the amount of organic titanate should not be so great as to influence the ultraviolet radiation curing mechanism. A preferred range of organic titanate is from 0.05 to 1 weight percent based on the total weight of the composition. A preferred organic titanate is tetrabutyl titanate.

The compositions of this invention can contain a reactive diluent to reduce the viscosity of the composition and to provide tougher cured films and coatings. The reactive diluent must be compatible with the rest of the ingredients of the composition and react during the curing processes so that they become part of the cured product. Reactive diluents which were found to be especially useful for these compositions include isobornyl acrylate, cyclohexyl acrylate, and 2-ethylhexyl acrylate. The compositions can also contain small amounts of multifunctional acrylates, such as up to 10 weight percent based on the weight of the composition.

The compositions of the present invention have two photocurable polymers, i.e. the acrylamide functional polyorganosiloxane and the methacryloxy functional polydiorganosiloxane. This two polymer combination cures faster when exposed to ultraviolet radiation than compositions containing only the methacryloxy functional polydiorganosiloxanes. The methacryloxy functional polydiorganosiloxane is required because it provides the groups which have the ability to moisture cure. The compositions of the present invention also cure to clear materials. This characteristic is observed when materials, which would otherwise be incompatible when reacted, coreact. If the two functional polymers did not coreact, the cured products would result in hazy or opaque materials, if they cured at all.

The compositions of the present invention have a combination of properties including being solventless, being low in viscosity, and curing to flexible materials exhibiting cold temperature flexibility. Being solventless and low in viscosity is a desirable combination for coatings such as would be useful as conformal coatings for printed circuit boards, especially when they have dual cure, UV and moisture, and when the resulting cured films and coatings have low temperature flexibility.

The compositions of the present invention are particularly useful as conformal coatings for printed circuit boards or printed wire boards, depending on the terminology one desires to use. For the purposes of the present invention these terms are interchangeable. Compositions which are especially useful coatings for these boards have low viscosities, so that the boards can be dip coated or spray coated, and cured to an acceptable tough coating. These compositions have a viscosity at 25° C. in the range of 0.07 to 0.2 Pa•s and comprise at least 20 weight percent of (A), polydimethylsiloxane having acrylamide functional groups at the polymer ends; at least 20 weight percent of (B) polydiorganosiloxane having endgroups containing both alkoxy groups and methacrylate groups where there are two alkoxy groups per endgroup bonded to silicon through an Si-O bond and one methacrylate group bonded to silicon through an Si-C bond and having less than 350 diorganosiloxane units per molecule, where said diorganosiloxane units are selected from the group consisting of dimethylsiloxane units, diphenylsiloxane units, and methylphenylsiloxane units wherein

at least 50 percent of the organic groups of the diorganosiloxane units are methyl; at least 20 weight percent of a reactive diluent selected from the group consisting of isobornyl acrylate, cyclohexyl acrylate, and 2-ethylhexyl acrylate, 0.5 to 10 weight percent of a photoinitiator which is compatible with (A) and (B), and 0.05 to 1 weight percent of an organic titanate. The preferred compositions cure by exposure to a dose of ultraviolet radiation in the amount of as little as 200 millijoules per square centimeter (in an inert atmosphere such as nitrogen) and still moisture cure in the shadow areas or dark areas, i.e. where the composition is not exposed to the ultraviolet radiation. The compositions require high doses of ultraviolet radiation to cure in air, but readily cure under an inert atmosphere such as nitrogen. Other Preferred compositions are those having polydimethylsiloxane (A) having on the average from 20 to 125 dimethylsiloxane units per molecule, polydiorganosiloxane of (B) being Polydimethylsiloxane having on the average from 10 to 50 dimethylsiloxane units per molecule, and the reactive diluent is isobornyl acrylate.

The source of the ultraviolet radiation is not critical as long as cure can be obtained. It is preferred to use a broad spectrum wavelength ultraviolet source for radiating the composition to provide cure. Many sources are available commercially.

The following examples are illustrative of the invention which is properly delineated in the claims. In the following examples, part or parts represent parts by weight and the viscosity measurements are at 25°C. unless otherwise stated. The compositions in the following examples were cured in an air atmosphere using an LCU (laboratory curing unit) from UVEXS, Inc, Mountain View, California, which had a stainless steel belt on which the samples were placed for curing and which had belt speeds of 1.52 to 7.11 centimeter per second (3 to 14 feet per minute). This LCU had a medium pressure mercury vapor 15.24 cm (six inch) lamp with a power of 200 watts per 2.54 cm (inch). The dosage was controlled by the belt speed and the number of passes through the LCU. The dosages were measured by using an International Light Company compact radiometer.

## EXAMPLE 1

A composition which cured by both ultraviolet radiation and moisture was prepared by blending 2.5 parts of 2-hydroxy-2-methylphenylpropanone (Photoinitiator 1 = PI-1) into 30 parts of isobornyl acrylate which was in turn blended with 30 parts of a polydiorganosiloxane (Polymer A) of the following average formula

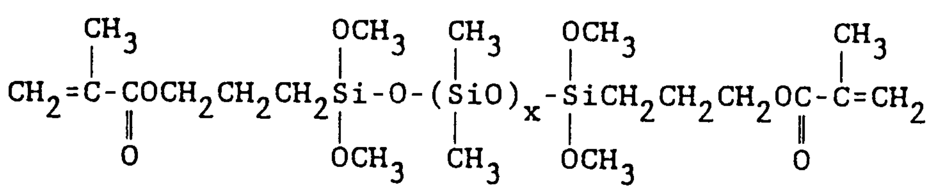

where the polydiorganosiloxane was 19 parts wherein x had an average value of 30 and 11 parts wherein x had an average value of 300, 37.3 parts of a polydiorganosiloxane (Polymer B) of the following average formula

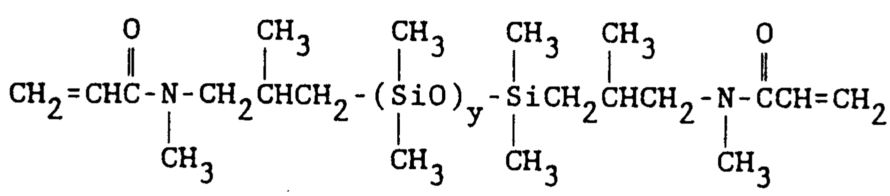

in which y had an average value of about 100, and 0.2 part of tetrabutyl titanate. The resulting mixture had a viscosity at 25°C. of 0.1 Pa•s. Test coupons were prepared by dip coating and provided a film of 1 to 3 mils thickness and then exposing them to a dose of 1500 millijoule per square centimeter ($mJ/cm^2$) by passing the coated panel under an ultraviolet lamp where each pass provides 750 $mJ/cm^2$. The test coupons were 2.54 cm (one inch) by 7.62 cm (three inch) copper clad FR-4 epoxy glass laminates which were carefully cleaned before coating. The cured film had a fair to good toughness and an initial Young's modulus at -65°C. of 6 x $10^7$ Pa. The coating had a thermal coefficient of expansion of 282 ppm. The coating had an excellent thermal shock characteristic and passed more than 1000 cycles. A cycle was 30

minutes at -65 °C. and 30 minutes at 125 °C. where the coupon went directly from one temperature environment to the other. A failure was observed when cracks in the coating appeared or if any delamination occurred. Salt fog test were conducted on test coupons, prepared as described above, passed more than 100 hours in the salt fog chamber, ASTM-B-117-73. Failure was observed when the copper exhibited corrosion or the coating softened, blistered, cracked or delaminated. The moisture cure was determined by allowing the coated coupons to stay in the dark for 16 hours and then observing the cure by removing the coating from the coupon. The coated coupons of the composition of this example were cured in 16 hours.

EXAMPLE 2

A composition which cured by ultraviolet radiation was prepared by mixing 49 parts of Polymer B, 40 parts of Polymer A, 2.5 parts of PI-1, and 10 parts of a resin copolymer having trimethylsiloxy units, silicon dioxide units, hydroxysilsequioxane units, dimethylsiloxane units, and units of the formula

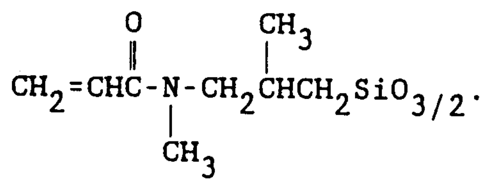

The resulting mixture had a viscosity at 25 °C. of 0.22 Pa•s. Test coupons were prepared as described in Example 1 and the same test were conducted. This composition was weak material and passed more than 1000 thermal shock cycles, more than 100 hours of salt fog, and had an initial Young's modulus at -65 °C. of 1 x $10^8$ Pa. The coating had a thermal coefficient of expansion of 4111 ppm. This composition could find use as a potting or encapsulating material where strength is not a requirement. When a catalytic amount of an organic titanate is added to this composition, such as tetrabutyl titanate, it cures when exposed to the atmosphere in the dark (shadow cure).

EXAMPLE 3

A composition (Formulation X) was prepared by blending 32.65 parts of Polymer B where y has a value of about 90, 32.65 parts of Polymer A where x has a value of about 30, 32 parts of isobornyl acrylate, 2.5 parts PI-1 and 0.2 part of tetrabutyl titanate. Another composition (Formulation Y) was prepared by blending 65.4 parts of Polymer A, 32 parts of isobornyl acrylate, 2.5 parts of PI-1, and 0.2 part of tetrabutyl titante. Each formulation was coated on Q-panels to give a 0.01524 cm (5-mil) wet film. The coated Q-panels were exposed in air to ultraviolet radiation from the LCU at 14 feet per minute. Formulation Y took forty passes to cure whereas Formulation X took only four passes. The combination of acrylamide polyorganosiloxane and methacryloxy/alkoxy polydiorganosiloxane cured ten times as fast in air as the methacryloxy/alkoxy polydiorganosiloxane.

COMPARATIVE EXAMPLE 1

A composition was prepared by blending 2.5 parts of PI-1 into 39.5 parts of isobornyl acrylate and then mixing with 35 parts of Polymer B, and 23 parts of a polymer of the same formula as Polymer B but where y had an average value of about 50. The resulting mixture had a viscosity of 0.174 Pa•s and test coupons cured by one pass under the UV lamp which provided a dose of 750 mJ/$cm^2$. The coating had an initial Young's modulus at -65 °C. of 8 x $10^8$ Pa and a thermal coefficient of expansion of 236 ppm. The test coupons passes 1000 thermal shock cycles and more than 100 hours of salt fog without failure. However, when stored in the dark for 16 hours, the coupons did not cure.

COMPARATIVE EXAMPLE 2

A composition was prepared by blending 2.5 parts of PI-1 with 37.3 parts of isobornyl acrylate and 10 parts of 2-ethylhexyl acrylate and then mixed with 50 parts of Polymer B and 0.2 part of tetrabutyl titanate. The resulting mixture has a viscosity of 0.085 Pa•s. Test coupons were made using this composition and then cured by one pass under an ultraviolet lamp which provided a dose of 750 mJ/$cm^2$. The coating

passed more than 1000 thermal shock cycles and more than 100 hours of salt fog. A film of the cured composition had a tensile strength at break of 4,418 kPa and an elongation at break of 342%. This composition does not moisture cure.

COMPARATIVE EXAMPLE 3

A composition was prepared by blending 2.5 parts of PI-1 with 20 parts of isobornyl acrylate and then mixing the blend with 77.5 parts of a polymer of the same formula as Polymer B except that the average value of $\underline{y}$ was about 300. The resulting mixture had a viscosity of 0.5 Pa•s and cured with one pass under an ultraviolet lamp which provided a dose of 750 mJ/cm$^2$. The cured film was a weak elastomer. This composition did not moisture cure.

EXAMPLE 4

A composition was prepared by mixing 48.7 parts of a polymer of the same formula as Polymer B except that $\underline{y}$ had an average value of about 600, 48.7 parts of a polymer of the same formula as Polymer A except that $\underline{x}$ had an average value of about 35, 2.1 parts of PI-1, and 0.5 part of tetrabutyl titanate. The composition was coated on an aluminum panel to provide a coat having a thickness of 0.01524 cm (5 mils). Exposing the coated panel to a dose of 1200 mJ/cm$^2$ of ultraviolet radiation cured the composition to a soft and flexible film which exhibited surface smearing. The composition exposed to the atmosphere and stored in the dark cured in less than 16 hours, thus the composition is a dual cure composition having ultraviolet radiation cure and moisture shadow cure.

EXAMPLE 5

A composition (Formulation A) was prepared by mixing 67 parts of an acrylamide polyorganosiloxane having trimethylsiloxy endblocking units, 96.3 mol percent dimethylsiloxane units, and 3.5 mol percent of acrylamide siloxane units of the formula

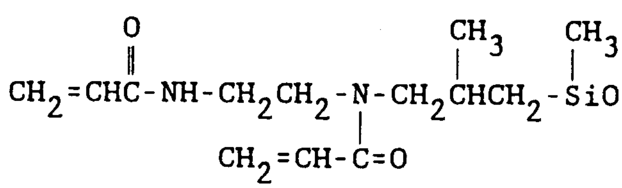

and which had an average of about 1000 units per molecule, 30.4 parts of a polymer of the same formula as Polymer A except that $\underline{x}$ had an average value of 35, 2.1 parts of PI-1, and 0.5 part of tetrabutyl titanate. A film cured in the same manner as described in Example 4 was a semi-rigid solid and had surface smearing. Composition exposed to the atmosphere and stored in the dark cured in less than 16 hours, thus this composition was a dual curing composition with shadow cure characteristics.

Another composition (Formulation B) was prepared as described above for Formulation A except that the acrylamide polyorganosiloxane had 95.2 mol percent dimethylsiloxane units and 3.2 mol percent of the acrylamide siloxane units and had an average of about 125 siloxane units per molecule. This composition cured with the same dosage of UV radiation as was Formulation A but the semi-rigid cured product was a tougher material than the UV cured product of Formulation A. This composition also moisture cured in less than 16 hours when exposed to the atmosphere in the dark, thus this composition is also a dual cure composition with shadow cure characteristics.

A composition (Formulation C) was prepared as described above for Formulation B except that 48.7 parts of the acrylamide polyorganosiloxane and 48.7 parts of the polymer having the same general formula as Polymer A was used. This composition cured by exposure to UV radiation (1200 mJ/cm$^2$) to a semi rigid solid very similar to the product obtained from UV curing Formulation B. This composition cured by exposure to the atmosphere and stored in the dark for 16 hours. This composition is a dual cure composition with shadow cure characteristics.

EXAMPLE 6

A composition was prepared by blending 67 parts of an acrylamide polyorganosiloxane having an

average of about 300 siloxane units per molecule and having trimethylsiloxy units as endblocking units, 98.7 mol percent dimethylsiloxane units, and 0.7 mol percent of acrylamide siloxane units as described in Example 5, 30.4 parts of a polymer of the same formula as Polymer A except that x had an average value of 35, 2.1 parts of PI-1, and 0.5 part of tetrabutyl titanate. This composition was exposed to UV radiation in the same manner as in Example 5, however, it did not cure as rapidly and the dose was increase to 1800 mJ/cm$^2$ to obtain a cure. The cured film was a soft and flexible solid but had an oily surface indicating that the amount of acrylamide functionality of the acrylamide polyorganosiloxane was too low to obtain a good cure. This composition was exposed to the atmosphere in the dark and in less than 16 hours it had cured. The composition is therefore a dual cure composition with moisture shadow cure characteristics.

EXAMPLE 7

A composition was prepared by blending 2.5 parts of PI-1 with 30 parts of isobornyl acrylate and then mixing the blend with 37.3 parts of Polymer B in which y had an average value of about 100, and 20 parts of Polymer A where the polydiorganosiloxane was 6 parts wherein x had an average value of about 300 and 14 parts wherein x had an average value of about 32, 0.2 part of tetrabutyl titanate, 10 parts of gamma-methacryloxypropyltrimethoxysilane, and 200 ppm of para-methoxyphenol as a stabilizer. This composition had a viscosity of about 0.2 Pa•s, cured when exposed to UV radiation with a dose of 1200 mJ/cm$^2$, and cures when exposed to the atmosphere and stored in the dark in less than 16 hours. This composition is useful as a conformal coating for printed wire boards. A nitrogen atmosphere is desirable for ultraviolet radiation curing because the cure is slow in air and the surface in not well cured.

EXAMPLE 8

A composition was prepared by blending 2.5 parts of PI-1 with 30 parts of isobornyl acrylate which was in turn mixed with 37.3 parts of the Polymer B of Example 7, 30 parts of Polymer A where the polydiorganosiloxane was 9 parts wherein x had an average value of about 300 and 21 parts wherein x had an average value of about 30, and 0.2 part of tetrabutyl titanate. The resulting mixture had a viscosity of 0.11 Pa•s and cured to a film which had a Shore A durometer of 55 when cured by exposure to ultraviolet radiation with a dose of 1500 mJ/cm$^2$ at 3.05 centimeter per second (6 feet/minute) under an air atmosphere. The surface of the cured film was slightly tacky, but was not oily. This composition cured in less than 24 hours when exposed to the atmosphere and stored in the dark. This composition is useful as a conformal coating because it cures with both UV radiation and exposure to moisture (shadow cure characteristic).

EXAMPLE 9

A composition (Formulation D) was prepared by blending 2.5 parts of 2-methyl-1-[4-(methylthio)phenyl]-2-morpholenopropanone with 32 parts of isobornyl acrylate and then mixed with 37.3 parts of Polymer B as described in Example 8, 28 parts of Polymer A where the polydiorgano siloxane was 7 parts wherein x had an average value of 300 and 21 parts wherein x had an average value of about 30, and 0.1 part of tetrabutyl titanate. Q-panels were coated by a drawdown method to provide a thickness of about 0.01524 cm (5 mils). The coated Q-panels were then exposed to ultraviolet radiation by passing the panels under a UV lamp at the rate of 7.11 centimeter per second (14 feet per minute), four time, to provide a dose of 1200 mJ/cm$^2$. The film cured to an excellent coating. The coating was observed after two days exposure to the atmosphere and was found to be a tough film.

A composition (Formulation E) was prepared as described above for Formulation D except that 2.5 parts of hydroxycyclohexyl phenyl ketone replaced the 2.5 parts of 2-methyl-1-[4 (methylthio)phenyl]-2-morpholenopropanone. Curing the composition in the same manner as described above for Formulation D, the cure by UV was not as good as Formulation D but did cure to a tough film after two days exposure to the atmosphere and was equiva]ent to the film obtained for Formulation D.

A composition (Formulation F) was prepared as described above for Formulation D except that 2 parts of benzophenone replaced the 2.5 parts of 2-methyl-1-[4-(methylthio)phenyl]-2-morpholenopropanone. This composition was exposed to ultraviolet radiation at a dosage of 2400 mJ/cm$^2$ but it did not cure. The composition was also exposed to the atmosphere and it cured in 16 hours.

**Claims**

1. A composition comprising
   (A) at least 10 weight percent based on the total weight of the composition of an acrylamide polyorganosiloxane having at least two organic groups which have acrylamide group functionality bonded to silicon atoms through Si-C bonds and on the average at least 20 but less than 1500 siloxane units per molecule, the organic groups bonded to the silicon atoms other than those having the acrylamide group functional are selected from the group consisting of methyl, ethyl, propyl and phenyl,
   (B) at least 20 weight percent based on the total weight of the composition of a polydiorganosiloxane having endgroups where there are two alkoxy groups per endgroup bonded to silicon through an Si-O bond and one methacrylate group bonded to silicon atoms through Si-C bonds and having on the average less than 350 diorganosiloxane units per molecule, said diorganosiloxane units being selected from dimethylsiloxane units, diphenylsiloxane units, and methylphenylsiloxane units wherein at least 50 percent of the organic groups of the diorganosiloxane are methyl,
   (C) from 0.5 to 10 weight percent based on the total weight of the composition of a photoinitiator which is compatible with (A) and (B), and
   (D) a catalytic quantity of an organic titanate sufficient to cause a curing reaction when exposed to moisture after the composition is exposed to ultraviolet radiation.

2. The composition according to claim 1 in which the organic groups other than those having the acrylamide functionality in (A) are methyl and the diorganosiloxane units of (B) are dimethylsiloxane units.

3. The composition according to claim 1 further comprising a reactive diluent.

4. The composition according to claim 3 in which the reactive diluent is selected from the group consisting of isobornyl acrylate, cyclohexyl acrylate, 2-ethylhexyl acrylate, multifunctional acrylates and mixtures thereof.

5. The composition according to claim 2 further comprising a reactive diluent.

6. The composition according to claim 5 in which the reactive diluent is selected from the group consisting of isobornyl acrylate, cyclohexyl acrylate, 2-ethylhexyl acrylate, multifunctional acrylates and mixtures thereof.

7. The composition according to claim 3 in which the composition has a viscosity at 25°C. in the range of 0.07 to 0.2 Pa•s.

8. The composition according to claim 5 in which the composition has a viscosity at 25°C. in the range of 0.07 to 0.2 Pa•s.

**Patentansprüche**

1. Zusammensetzung, enthaltend
   (A) mindestens 10 Gew.-%, bezogen auf Gesamtgewicht der Zusammensetzung, eines Acrylamid-Polyorganosiloxans mit mindestens zwei organischen Gruppen, die Acrylamidgruppenfunktionalität aufweisen, die an Siliziumatome über Si-C-Bindungen gebunden sind, und mit im Mittel mindestens 20, jedoch weniger als 1500 Siloxaneinheiten pro Molekül, wobei die organischen Gruppen, die an Siliziumatome gebunden sind, außer denen mit Acrylamidgruppenfunktionalität, aus der aus Methyl, Ethyl, Propyl und Phenyl bestehenden Gruppe ausgewählt sind,
   (B) mindestens 20 Gew.-%, bezogen auf Gesamtgewicht der Zusammensetzung, eines Polydiorganosiloxans mit Endgruppen, an denen zwei Alkoxygruppen pro Endgruppe an Siliziumatome durch Si-O-Bindung gebunden sind und eine Methacrylatgruppe an Siliziumatome durch Si-C-Bindungen gebunden ist, und mit im Mittel weniger als 350 Diorganosiloxaneinheiten pro Molekül, wobei die Diorganosiloxaneinheiten ausgewählt sind aus Dimethylsiloxaneinheiten, Diphenylsiloxaneinheiten und Methylphenylsiloxaneinheiten, wobei mindestens 50% der organischen Gruppen des Diorganosiloxans Methyl sind,
   (C) von 0,5-10 Gew.-%, bezogen auf Gesamtgewicht der Zusammensetzung, eines Photoinitiators, der mit (A) und (B) verträglich ist, und

(D) eine katalytische Menge eines organischen Titanats, ausreichend, um die Härtungsreaktion auszulösen, wenn die Zusammensetzung nach dem Aussetzen ultravioletter Strahlung Feuchtigkeit ausgesetzt wird.

**2.** Zusammensetzung nach Anspruch 1,
**dadurch gekennzeichnet,**
daß die organischen Gruppen, außer denen mit Acrylamidfunktionalität, in (A) Methyl und die Diorganosiloxaneinheiten von (B) Dimethylsiloxaneinheiten sind.

**3.** Zusammensetzung nach Anspruch 1,
**dadurch gekennzeichnet,**
daß sie weiterhin ein reaktives Verdünnungsmittel enthält.

**4.** Zusammensetzung nach Anspruch 3,
**dadurch gekennzeichnet,**
daß das reaktive Verdünnungsmittel aus der aus Isobornylacrylat, Cyclohexylacrylat, 2-Ethylhexylacrylat, multifunktionellen Acrylaten und Mischungen derselben bestehenden Gruppe ausgewählt ist.

**5.** Zusammensetzung nach Anspruch 2,
**dadurch gekennzeichnet,**
daß sie weiterhin ein reaktives Verdünnungsmittel enthält.

**6.** Zusammensetzung nach Anspruch 5,
**dadurch gekennzeichnet,**
daß das reaktive Verdünnungsmittel aus der aus Isobornylacrylat, Cyclohexylacrylat, 2-Ethylhexylacrylat, multifunktionellen Acrylaten und Mischungen derselben bestehenden Gruppe ausgewählt ist.

**7.** Zusammensetzung nach Anspruch 3,
**dadurch gekennzeichnet,**
daß die Zusammensetzung bei 25 ° C eine Viskosität im Bereich von 0,07-0,2 Pa.s aufweist.

**8.** Zusammensetzung nach Anspruch 5,
**dadurch gekennzeichnet,**
daß die Zusammensetzung bei 25 ° C eine Viskosität im Bereich von 0,07-0,2 Pa.s aufweist.

## Revendications

**1.** Une composition comprenant

(A) au moins 10 pour cent en poids, par rapport au poids total de la composition, d'un acrylamide-polyorganosiloxane comportant au moins deux groupes organiques à fonctionnalité acrylamide liés aux atomes de silicium par des liaisons Si-C, et contenant en moyenne au moins 20 mais moins de 1500 motifs siloxanes par molécule, les groupes organiques liés aux atomes de silicium, autres que ceux ayant la fonctionnalité acrylamide, étant choisis dans la classe formée par les groupes méthyle, éthyle, propyle et phényle,

(B) au moins 20 pour cent en poids, par rapport au poids total de la composition, d'un polydiorganosiloxane comportant des motifs terminaux où se trouvent, par motif terminal, deux groupes alcoxy liés au silicium par une liaison Si-O et un groupe méthacrylate lié au silicium par une liaison Si-C, et contenant en moyenne moins de 350 motifs diorganosiloxanes par molécule, lesdits motifs diorganosiloxanes étant choisis parmi les motifs diméthylsiloxane, les motifs diphénylsiloxane et les motifs méthylphénylsiloxane, et au moins 50 pour cent des groupes organiques du diorganosiloxane étant des groupes méthyle,

(C) 0,5 à 10 pour cent en poids, par rapport au poids total de la composition, d'un photo-initiateur qui est compatible avec (A) et (B), et

(D) une quantité catalytique d'un titanate organique, suffisante pour provoquer une réaction de durcissement par exposition à l'humidité après que la composition a été exposée à un rayonnement ultraviolet.

**2.** La composition selon la revendication 1, dans laquelle les groupes organiques autres que ceux ayant la

fonctionnalité acrylamide dans (A) sont des groupes méthyle et les motifs diorganosiloxanes de (B) sont des motifs diméthylsiloxane.

**3.** La composition selon la revendication 1, comprenant de plus un diluant réactif.

**4.** La composition selon la revendication 3, dans laquelle le diluant réactif est choisi dans le groupe formé par l'acrylate d'isobornyle, l'acrylate de cyclohexyle, l'acrylate de 2-éthylhexyle, des acrylates multifonctionnels et leurs mélanges.

**5.** La composition selon la revendication 2, comprenant de plus un diluant réactif.

**6.** La composition selon la revendication 5, dans laquelle le diluant réactif est choisi dans le groupe formé par l'acrylate d'isobornyle, l'acrylate de cyclohexyle, l'acrylate de 2-éthylhexyle, des acrylates multifonctionnels et leurs mélanges.

**7.** La composition selon la revendication 3, dans laquelle la viscosité à 25°C de la composition est comprise dans l'intervalle de 0,07 à 0,2 Pa.s.

**8.** La composition selon la revendication 5, dans laquelle la viscosité à 25°C de la composition est comprise dans l'intervalle de 0,07 à 0,2 Pa.s.